# EUROPEAN PATENT SPECIFICATION

(11) **EP 3 223 328 B1**
(45) Date of publication and mention of the grant of the patent: **29.07.2020**
(21) Application number: 17162791.2
(22) Date of filing: 24.03.2017
(51) Int. Cl.: H01L 51/42

(54) **ORGANIC PHOTOVOLTAIC CELL AND MANUFACTURING METHOD THEREOF**
ORGANISCHE FOTOVOLTAIKZELLENVORRICHTUNG UND HERSTELLUNGSVERFAHREN DAFÜR
CELLULE PHOTOVOLTAÏQUE ORGANIQUE ET SON PROCÉDÉ DE FABRICATION

(30) Priority: 25.03.2016 KR 20160036362; 22.03.2017 KR 20170036347
(43) Date of publication of application: 27.09.2017
(73) Proprietor: Kolon Industries, Inc., Seoul 07793 (KR)
(72) Inventor: CHO, Geun-Sang, 16910 Gyeonggi-do (KR); MOON, Jeong-Yeol, 16910 Gyeonggi-do (KR); PARK, Hong-Kwan, 16910 Gyeonggi-do (KR); KIM, Kwang-Su, 16910 Gyeonggi-do (KR)
(74) Representative: Ter Meer Steinmeister & Partner

(56) References cited:
- WO-A2-2014/154360
- KUMAR VIKAS ET AL: "High-efficiency inverted polymer solar cells via dual effects of introducing the high boiling point solvent and the high conductive PEDOT:PSS layer", ORGANIC ELECTRONICS, vol. 15, no. 9, 20 June 2014 (2014-06-20), pages 2059-2067, XP028880366, ISSN: 1566-1199, DOI: 10.1016/J.ORGEL.2014.06.001
- YULIA GALAGAN ET AL: "Roll-to-Roll Slot-Die Coated Organic Photovoltaic (OPV) Modules with High Geometrical Fill Factors", ENERGY TECHNOLOGY, vol. 3, no. 8, 6 August 2015 (2015-08-06), pages 834-842, XP055396954, DE ISSN: 2194-4288, DOI: 10.1002/ente.201500150
- CHENGXI ZHANG ET AL: "Investigation of Poly(3,4-ethylenedioxythiophene):Poly(styr enesulfonate) Hole Transport Layer for Solution-Processed Polymer Solar Cells", INTERNATIONAL JOURNAL OF PHOTOENERGY, vol. 2015, 10 September 2015 (2015-09-10), pages 1-7, XP055396855, US ISSN: 1110-662X, DOI: 10.1155/2015/893916

## Description

### [Technical Field]

The present disclosure relates to an organic photovoltaic cell having enhanced performance, lifespan and reliability, and a method for manufacturing the same.

### [Background Art]

Problems such as oil price rising, global environmental problems, fossil energy depletion and nuclear power generation waste disposal have recently heightened interests in new and renewable energy, and among these, research and development on photovoltaic cells as a pollution free energy source have been actively ongoing.

Photovoltaic cells are largely divided into inorganic photovoltaic cells and organic photovoltaic cells. Among these, organic photovoltaic cells convert solar energy to electric energy using high molecular or low molecular organic semiconductors, and have advantages of low costs and simple manufacturing processes, which are biggest advantages of organic materials.

Particularly, an organic photovoltaic cell having an inverted electrode structure in which a transparent electrode such as ITO served as a negative electrode and a metal electrode served as a positive electrode has an advantage in that it can prevent decreases in lifetime and efficiency of a device caused by oxidation.

An inverted electrode-structured organic photovoltaic cell normally has a thin film-type structure having a multilayer structure in which a plurality of layers such as a negative electrode, an electron transfer layer, a photoactive layer, a hole transfer layer and a positive electrode are laminated. The thin film-type organic photovoltaic cell may be manufactured using various coating methods such as slot die coating, spray coating, spin coating and gravure coating. However, when laminating a hydrophilic hole transfer layer on a photoactive layer having hydrophobicity through a spin coating method and the like, a quality of the thin film declines, leading to a problem of exhibiting low energy conversion efficiency of approximately 1% to 2%, and therefore, a roll-to-roll-type slot die coating method is mainly used more preferably.

However, when forming a multilayer thin film structure through a slot die coating method and the like, mass production of organic photovoltaic cells according with target design values may not be accomplished since thin films having constant width and thickness are not repeatedly produced depending on solution viscosity, users and manufacturing environments.

Particularly, binding defects occur between a hydrophobic photoactive layer and a hydrophilic hole transfer layer, which causes a problem of deterioration in performance and lifespan of an organic photovoltaic cell.

### [Prior Art Documents]

### [Non-patent Documents]

Aung Ko Ko Kyaw et al., An inverted organic solar cell employing a sol-gel derived ZnO electron selective layer and thermal evaporated MoO3 hole selective layer, Appl. Phys. Lett.,2008, 93, 221107.

Kumar, V. et al in Organic Electronics, vol. 15, no. 9, pages 2059-2067 discloses an inverted polymer solar cell comprising a high conductive PEDOT:PSS (hcPEDOT:PSS)between a Au nanoparticles (NPs)-embedded hole transport layer (PEDOT:PSS) and the top electrode layer.

### [Disclosure]

### [Technical Problem]

The present disclosure has been made in view of the above problems, and by having two hole transfer layers with different sheet resistance using compositions for forming a hole transfer layer with different viscosity, instability at an interface caused by a difference in the surface energy between the hole transfer layer and a photoactive layer is improved and processibility is enhanced, and as a result, performance, lifespan and reliability of an organic photovoltaic cell are improved.

Accordingly, it is an object of the present disclosure to provide an organic photovoltaic cell having excellent performance, lifespan and reliability.

In addition, it is another object of the present disclosure to provide a method for manufacturing the organic photovoltaic cell.

### [Technical Solution]

One embodiment of the present disclosure provides an organic photovoltaic cell, comprising: a substrate; a lower electrode; an electron transfer layer; a photoactive layer; a first hole transfer layer; a second hole transfer layer and an upper electrode are sequentially laminated on the substrate, wherein the first hole transfer layer has higher sheet resistance than the second hole transfer layer, wherein the first hole transfer layer has a thickness of 100 nm to 500 nm, and, the second hole transfer layer has a thickness of 1000 nm to 5000 nm.

Another embodiment of the present disclosure provides a method for manufacturing an organic photovoltaic cell including,
1) forming a lower electrode on a substrate;
2) forming an electron transfer layer on the lower electrode using a composition for forming an electron transfer layer;
3) forming a photoactive layer on the electron transfer layer using a composition for forming a photoactive layer;
4) forming a first hole transfer layer on the photoactive layer using a composition for forming a first hole transfer layer;
5) forming a second hole transfer layer on the first hole transfer layer using a composition for forming a second hole transfer layer; and
6) forming an upper electrode on the second hole transfer layer,
wherein the first hole transfer layer is formed using a composition having lower viscosity than the composition for forming a second hole transfer layer, wherein the first hole transfer layer has a thickness of 100 nm to 500 nm, and, the second hole transfer layer has a thickness of 1000 nm to 5000 nm.

### [Advantageous Effects]

An organic photovoltaic cell of the present disclosure includes first and second hole transfer layers having different sheet resistance. Each of these hole transfer layers is formed with each composition for forming a hole transfer layer using a different solvent and having different viscosity. Therefore, the organic photovoltaic cell according to the present disclosure solves the problem of instability at an interface caused when forming the hole transfer layer on a photoactive layer is minimized, and the layers can be prepared to have thicknesses and linewidths according with design values. Thus, performance, lifespan and reliability of the organic photovoltaic cell can be enhanced.

### [Description of Drawings]

FIG. 1 is a sectional view of an organic photovoltaic cell according to one embodiment of the present disclosure.
FIG. 2 is a mimetic diagram for explaining pattern changes between a photoactive layer and a hole transfer layer before and after drying in an organic photovoltaic cell.
FIG. 3 is a graph showing performance of maintaining power-conversion efficiency of organic photovoltaic cells according to an example and a comparative example depending on the passage of time.

### [Mode for Disclosure]

Hereinafter, preferred embodiments of the present disclosure will be described in detail with reference to the accompanying drawings. However, embodiments of the present disclosure are for illustrative purposes only, and the present disclosure is not limited to the following embodiments. The present disclosure may be modified to various other forms within the scope of the present disclosure, and the scope of the present disclosure will be determined by technological ideas of the appended claims.

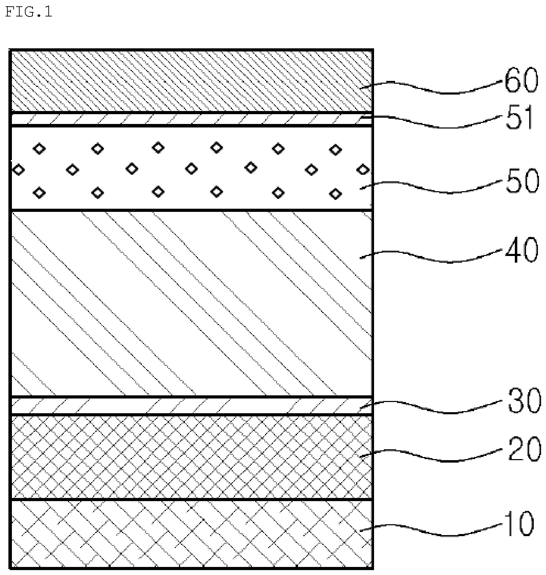

FIG. 1 is a sectional view of an organic photovoltaic cell according to one embodiment of the present disclosure.

When referring to FIG. 1, an organic photovoltaic cell according to one embodiment of the present disclosure includes a lower electrode (20), an electron transfer layer (30), a photoactive layer (40), a first hole transfer layer (50), a second hole transfer layer (51) and an upper electrode (60) sequentially laminated on a substrate (10).

Such an organic photovoltaic cell having a multilayer thin film structure is manufactured through a solution-based coating process, and as described above, surface energy between the photoactive layer and the hole transfer layer is different, and an interface between these two layers is unstable causing a problem of binding defects. Such a problem of binding defects reduces performance, lifespan and reliability of the organic photovoltaic cell as well as making it difficult to provide process uniformity and process stability.

In view of the above, an organic photovoltaic cell according to the present disclosure includes two hole transfer layers having different sheet resistance. As these two hole transfer layers are formed by each composition for forming a hole transfer layer using a different solvent and having different viscosity, a binding property between a photoactive layer and a hole transfer layer occurring in an existing organic photovoltaic cell is improved, and performance, lifespan and reliability of an organic photovoltaic cell are enhanced.

Accordingly, the organic photovoltaic cell provided in the present disclosure includes a multilayer-structured hole transfer layer formed with a first hole transfer layer (50) and a second hole transfer layer (51), wherein the first hole transfer layer (50) and the second hole transfer layer (51) have different sheet resistance.

Sheet resistance (Rₛ) is a parameter for measuring physical properties of a thin film, particularly conductivity, and according to the Ohm's law, when flowing a current to a sample, a voltage decrease occurs due to resistance of the sample, and a method of calculating the resistance by measuring the voltage at the time may be used. As one example, the measurement may be made using a direct contact method using a 4-point probe equally spaced (1 mm) or a contactless method measuring an Eddy current provided by high-frequency induction. In the present disclosure, the measurement is made through a direct contact method using a 4-point probe method. The sheet resistance is closely related to electric power, transmittance and operating characteristics of a device, and low sheet resistance normally means having high electrical conductivity.

In order to function as a hole transfer layer, the second hole transfer layer (51) is prepared using known hole transfer layer materials and methods, and has a typical range of electrical conductivity (or common sheet resistance). Herein, in order to increase an interfacial property with the photoactive layer (40), the first hole transfer layer (vis50) is formed using a low viscosity composition so as to have high wettability, and has lower electrical conductivity, that is, higher sheet resistance, compared to the second hole transfer layer (51) due to a low content of a hole transfer material in the composition.

More detailed descriptions are as follows.

A sheet resistance difference between the two layers results from the viscosity difference of a composition for forming each of the layers. Specifically, the first hole transfer layer is formed with a composition having lower viscosity than a composition for forming a second hole transfer layer. Herein, the composition having low viscosity includes less hole transfer materials compared to the composition having high viscosity and thereby has relatively low conductivity. As a result, a difference occurs in the sheet resistance. In addition thereto, by forming the first hole transfer layer with the composition having low viscosity and using water as a solvent so as to have excellent wettability for a photoactive layer, the first hole transfer layer improves a binding property with the hydrophobic photoactive layer and minimizes contraction occurring during drying, and thereby performs a role of an interlayer enabling a second hole transfer layer laminated afterward to maintain form uniformity with the layers laminated previously. In addition, by forming the second hole transfer layer with the composition having higher viscosity compared to the composition for forming the first hole transfer layer and using an alcohol-based solvent on the first hole transfer layer, the second hole transfer layer performs a role of, together with a role of hole transfer, preventing diffusion of metal ions and impurities produced from an upper electrode laminated afterward.

In addition, the organic photovoltaic cell according to one embodiment the present disclosure may be manufactured using a method for manufacturing an organic photovoltaic cell including,
1) forming a lower electrode on a substrate;
2) forming an electron transfer layer on the lower electrode using a composition for forming an electron transfer layer;
3) forming a photoactive layer on the electron transfer layer using a composition for forming a photoactive layer;
4) forming a first hole transfer layer on the photoactive layer using a composition for forming a first hole transfer layer;
5) forming a second hole transfer layer on the first hole transfer layer using a composition for forming a second hole transfer layer; and
6) forming an upper electrode on the second hole transfer layer,
wherein, the first hole transfer layer is formed using a composition having lower viscosity than the composition for forming a second hole transfer layer, wherein the first hole transfer layer has a thickness of 100 nm to 500 nm, and, the second hole transfer layer has a thickness of 1000 nm to 5000 nm.

The substrate (10) in the present disclosure may use, as a material capable of being used in the technology field to which the present disclosure belongs, materials having transparency so as to transmit light without particular limit.

As the substrate (10), inorganic substrate films such as glass or quartz may be used. In addition to the inorganic substrate films described above, any one plastic substrate film selected from among polyethylene terephthalate (PET), polyethylene naphthalate (PEN), polypropylene (PP), polyimide (PI), polycarbonate (PC), polystyrene (PS), polyoxymethylene (POM), polyethylene sulfonate (PES), polyetheretherketone (PEEK), polyethersulfone (PES), polyetherimide (PEI), acrylonitrile styrene (AS), acrylonitrile butadiene styrene (ABS) and triacetyl cellulose (TAC) resin and the like may also be used.

Particularly, as the substrate (10), using those having high chemical stability, mechanical strength and transparency while being flexible may be preferred.

In addition, the substrate (10) favorably has transmissivity of at least 80% or greater in a visible wavelength region of approximately 400 nm to 750 nm.

A thickness of the substrate (10) is not particularly limited, and may be properly determined depending on the use. As one example, the thickness may be from 1 µm to 500 µm.

As the lower electrode (20) is a transparent electrode so that light transmitting the substrate reaches a photoactive layer (30). Preferably, the lower electrode (20) includes materials having high transparency, high work function of approximately 4.5 eV or greater and low resistance.

For example, the lower electrode (20) may include at least one oxides selected from the group consisting of indium tin oxide (ITO), fluorine-doped tin oxide (FTO), ZnO-Ga₂O₃, ZnO-Al₂O₃, SnO₂-Sb₂O₃ and combinations thereof; organic transparent electrodes such as conductive polymers, graphene, graphene oxide and carbon nanotubes; and organic-inorganic combined transparent electrodes such as metal-bonded carbon nanotubes, and the like. Preferably, the lower electrode (20) comprises indium tin oxide.

A thickness of the lower electrode (20) is not particularly limited, but may be from 10 nm to 3000 nm.

The lower electrode (20) is a negative electrode in the organic photovoltaic cell of the present disclosure, and may be formed by applying the lower electrode materials described above on one surface of the substrate (10) or coating the materials in a film form using a sputtering method, e-beam, thermal deposition, spin coating, screen printing, inkjet printing, doctor blade, a gravure printing method or the like.

As the method of forming the lower electrode (20), various methods used in the technology field to which the present disclosure belongs may be selected and used depending on a target pattern of the lower electrode (20). As one example, the lower electrode (20) patterned on the substrate (10) may be formed by screen printing an etch resist while transporting the substrate in a roll-to-roll manner, UV curing the result, then etching the result using an etching solution such as an aqueous copper chloride solution, and stripping the result using a stripping agent such as sodium hydroxide to form a pattern, and then washing and drying the result.

The electron transfer layer (30) is formed on the lower electrode (20), and the electron transfer layer (30) is an auxiliary electrode capable of activating the operation of an organic photovoltaic cell by increasing an electron transfer rate. In addition, the electron transfer layer (30) blocks oxygen and moisture penetrating from the outside, and prevents a polymer included in a photoactive layer (40) to be described later from being deteriorated by oxygen and moisture, and thereby increases a lifespan of an organic photovoltaic cell.

As one example for forming the electron transfer layer (30), a solution may be used. The electron transfer layer (30) is formed with the composition for forming an electron transfer layer (hereinafter, also referred to as a 'first solution'), and the composition may be used solutions suited for forming an electron transfer layer known in the technology field to which the present disclosure belongs without limit.

For example, the composition for forming an electron transfer layer may include at least one metal oxide selected from the group consisting of titanium (Ti), zinc (Zn), silicon (Si), manganese (Mn), strontium (Sr), indium (In), barium (Ba), potassium (K), niobium (Nb), iron (Fe), tantalum (Ta), tungsten (W), bismuth (Bi), nickel (Ni), copper (Cu), molybdenum (Mo), cerium (Ce), platinum (Pt), silver (Ag), rhodium (Rh) and combinations thereof. Preferably, zinc oxide (ZnO) has a large bandgap and a semiconductor property, and therefore, using zinc oxide with the lower electrode (20) described above may further enhance electron transfer.

In addition, the metal oxide has an average particle diameter of 10 nm or less, preferably 1 nm to 8 nm, and more preferably 3 nm to 7 nm.

The composition for forming an electron transfer layer also includes a solvent for dissolving the metal oxide described above, and a thin film is formed by coating the composition.

The solvent may be used without particular limit as long as it is capable of dissolving or dispersing the metal oxide described above. As one example, the solvent may be water; an alcohol such as ethanol, methanol, propanol, isopropyl alcohol and butanol; or an organic solvent such as acetone, pentane, toluene, benzene, diethyl ether, methylbutyl ether, N-methylpyrrolidone, tetrahydrofuran, dimethylformamide, dimethylacetamide, dimethyl sulfoxide, carbon tetrachloride, dichloromethane, dichloroethane, trichloroethylene, chloroform, chlorobenzene, dichlorobenzene, trichlorobenzene, cyclohexane, cyclopentanone, cyclohexanone, dioxane, terpineol, methyl ethyl ketone, or mixtures thereof. Preferably, the solvent is properly selected from among the above-mentioned solvents depending on the composition for forming an electron transfer layer.

The solvent may be included in the residual amount in the composition for forming an electron transfer layer. Preferably, the solvent may be 1% by weight to 95% by weight based on a total weight of the composition for forming an electron transfer layer. When the solvent content is greater than 95% by weight, it is difficult to obtain a desired function of the layer, and when the solvent content is less than 1% by weight, it is difficult to form a thin film having a uniform thickness.

As the method of coating the first solution, various methods known in the art may be used without limit. As one example, one or more types of methods may be selected from among a slot die coating method, a bar coating method, a meyer bar coating method, a spin coating method, a comma coating method, a curtain coating method, a microgravure coating method, an inkjet coating method, a spray coating method or a doctor blade coating method, and the method is not limited thereto.

The composition of the first solution may be controlled considering a thickness of a layer to form. As one example, when the first solution is a solution for forming the electron transfer layer, the composition of the first solution may be controlled so that a thickness of the electron transfer layer becomes from 10 nm to 50 nm and preferably approximately 30 nm. When the thickness of the electron transfer layer is within the thickness range in the above, it is preferably capable of effectively preventing a photoactive layer and a hole transfer layer from being affected by the penetration of oxygen and moisture from the outside while enhancing electrons transfer rate.

Drying temperature and time of the first solution may be properly controlled depending on the composition of the first solution used. As one example, the first solution may be dried for 1 minute to 3 minutes at a temperature of 100°C to 200°C.

The organic photovoltaic cell of the present disclosure has a multilayer structure in which a plurality of layers is laminated, and therefore, a plurality of layers may be formed by repeating the above-mentioned processes.

The photoactive layer (40) is located on the electron transfer layer (30) described above, and has a bulk heterojunction structure mixing a hole acceptor and an electron acceptor.

As one example for forming the photoactive layer (40), a solution may be used. The photoactive layer (40) may be formed by coating and then drying the composition for forming a photoactive layer (hereinafter, also referred to as a 'second solution'). The second solution may be used solutions suited for forming a photoactive layer known in the technology field to which the present disclosure belongs without limit.

Specifically, the second solution may be a solution for forming a photoactive layer having a bulk heterojunction structure mixing a hole acceptor and an electron acceptor.

The hole acceptor is an electroconductive polymer or an organic semiconductor such as an organic low molecular semiconductor material. The electroconductive polymer may be at least one selected from the group consisting of polythiophene, polyphenylene vinylene, polyfluorene, polypyrrole, and combinations thereof. The organic low molecular semiconductor material may be at least one selected from the group consisting of pentacene, anthracene, tetracene, perylene, oligothiophene, and combinations thereof.

Preferably, the hole acceptor may be at least one selected from the group consisting of poly-3-hexylthiophene [P3HT], poly-3-octylthiophene [P3OT], poly-p-phenylene vinylene [PPV], poly(9,9'-dioctylfluorene), poly(2-methoxy,5-(2-ethylhexyloxy)-1,4-phenylene vinylene) [MEH-PPV], poly(2-methyl,5-(3',7'-dimethyloctyloxy))-1,4-phenylene vinylene [MDMOPPV] and combinations thereof.

The electron acceptor may be at least one selected from the group consisting of fullerene derivatives such as fullerene (C₆₀) , C₇₀, C₇₆, C₇₈, C₈₀, C₈₂ and C₈₄, CdS, CdSe, CdTe, ZnSe, (6,6)-phenyl-C₆₁-butyric acid methyl ester [PCBM], (6,6)-phenyl-C₇₁-butyric acid methyl ester [C₇₀-PCBM], (6,6) -thienyl-C₆₁-butyric acid methyl ester [ThCBM], carbon nanotubes and combinations thereof.

Preferably, the electron acceptor may include at least one selected from the group consisting of (6,6)-phenyl-C₆₁-butyric acid methyl ester (PCBM), (6,6)-phenyl-C₇₁-butyric acid methyl ester (C₇₀-PCBM), (6, 6)-thienyl-C₆₁-butyric acid methyl ester (ThCBM) and carbon nanotubes.

More preferably, the composition for forming a photoactive layer includes a mixture of P3HT as the hole acceptor and PCBM as the electron acceptor. Herein, a mixing weight ratio of the P3HT and the PCBM may be from 1:0.1 to 1:2 and preferably from 1:1.5 to 1:2.

The composition for forming a photoactive layer includes a solvent together with the hole acceptor and the electron acceptor described above. Herein, types of the usable solvent are the same as described above.

The photoactive layer (40) forms a film by coating the composition for forming a photoactive layer. Herein, the coating may be carried out through at least one method selected from among a slot die coating method, a bar coating method, a meyer bar coating method, a spin coating method, a comma coating method, a curtain coating method, a microgravure coating method, an inkjet coating method, a spray coating method, a doctor blade coating method or the like. More preferably, a slot die coating method may be used.

After forming a film with the composition for forming a photoactive layer, a post-treatment process of drying or heat treating the coated substrate may be selectively carried out. The drying may be carried out through hot-air drying, NIR drying or UV drying for 1 minute to 30 minutes at 50°C to 400°C and preferably at 70°C to 200°C.

The photoactive layer (40) may have a thickness of 10 nm to 1000 nm, preferably 100 nm to 500 nm. When the thickness of the photoactive layer (40) is less than the above-mentioned range, sunlight may not be sufficiently absorbed causing a photocurrent decrease, and efficiency is expected to decrease, and when the thickness is greater than the above-mentioned range, excited electrons and holes may not be transferred to an electrode causing a problem of efficiency decline.

The first hole transfer layer (50) and the second hole transfer layer (51) perform a role of helping holes generated in the photoactive layer (40) to be transferred to an upper electrode (60) to be described later.

Herein, the first hole transfer layer (50) and the second hole transfer layer (51) are formed using a solution. The first hole transfer layer (50) and the second hole transfer layer (51) may form a thin film by coating the composition for forming a first hole transfer layer (hereinafter, also referred to as a 'third solution') and the composition for forming a second hole transfer layer (hereinafter, also referred to as a fourth solution'), respectively, and then drying the result.

In the present disclosure, the composition for forming a first hole transfer layer has viscosity lower than the composition for forming a second hole transfer layer. As described above, by the compositions having different viscosity, conducting properties of thin films formed therefrom become different, and therefore, the first hole transfer layer (50) and the second hole transfer layer (51) have different sheet resistance. In addition, with a difference in the viscosity described above, the composition for forming a first hole transfer layer uses water as a solvent reducing a surface energy difference with the photoactive layer (40) when forming a film, and as a result, a binding property with the photoactive layer (40) is improved.

Specifically, a viscosity ratio of the composition for forming a first hole transfer layer and the composition for forming a second hole transfer layer is 1:10 or more, preferably from 1:10 to 1:50. When the viscosity ratio is less than the above-mentioned range, no differences occur in the sheet resistance between the formed thin films and an effect of improving a binding property may not be obtained in the preparation. When the viscosity ratio is greater than the above-mentioned range, a problem of making fine thickness adjustment difficult may occur.

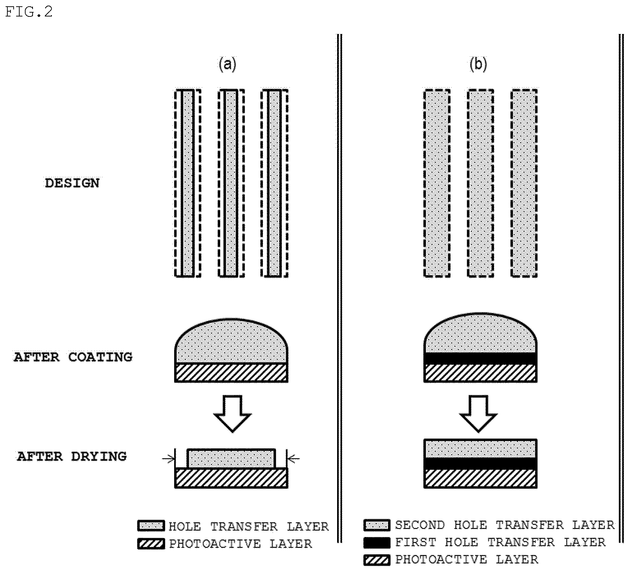

In the present disclosure, the first hole transfer layer (50) is formed with the composition having lower viscosity than the composition for forming a second hole transfer layer. According to the present disclosure, each composition for forming a hole transfer layer includes a hole transfer material and a solvent as described later. Herein, the composition having low viscosity includes relatively less hole transfer material compared to the composition having high viscosity, and therefore, conductivity is low and sheet resistance is high. Accordingly, the first hole transfer layer (50) is formed from the low viscosity composition and has high sheet resistance compared to the second hole transfer layer (51) to be described later. Specifically, the first hole transfer layer (50) has sheet resistance in a range of 1x10⁴ Ω/sq. to 1x10⁶ Ω/sq.. In addition, since the composition for forming a first hole transfer layer having low viscosity includes water as a solvent, the difference in surface energy with the photoactive layer (40) is minimized to improve wettability. Thereby the binding property with the hydrophobic photoactive layer (40) is improved and the first hole transfer layer performs a role of an interlayer enabling the second hole transfer layer (51) formed afterward to maintain form uniformity with the layers previously formed. This may be identified from a description on FIG. 2.

FIG. 2 is a mimetic diagram for explaining pattern changes between the photoactive layer and the hole transfer layer before and after drying in an organic photovoltaic cell.

When forming the hole transfer layer on the photoactive layer, the hole transfer layer is designed to be formed in a region corresponding to a dotted line as shown in (a) and (b) of FIG. 2.

According to FIG. 2(a), transverse direction (TD) contraction occurs in the hole transfer layer compared to the design pattern (dotted line) after drying in existing technologies. However, when forming two hole transfer layers according to the present disclosure, cross sections between the photoactive layer and the hole transfer layers are the same and no pattern changes such as the contraction occur, and a hole transfer layer having a pattern according with the design value is formed, as shown in FIG. 2(b). This may be obtained by forming the two hole transfer layers formed by the compositions having different viscosity. Particularly, by forming the first hole transfer layer that is positioned to directly adjoin the photoactive layer with the composition having low viscosity, and forming the second hole transfer layer on the top of the first hole transfer layer using the composition having high viscosity, the above-mentioned effect may be secured.

The second hole transfer layer (51) is formed with the composition having higher viscosity than the composition for forming a first hole transfer layer. As described above, the composition for forming a hole transfer layer having high viscosity includes relatively more hole transfer material, and therefore, conductivity is high and sheet resistance is low. Accordingly, the second hole transfer layer (51) has lower sheet resistance compared to the first hole transfer layer (50) described above, and the range is from 1x10² Ω/sq. to 1x10³ Ω/sq.. In addition, as well as having a hole transfer function, the second hole transfer layer (51) performs a role of blocking the penetration of impurities and metal ions generated from an upper electrode (70) formed thereon.

The third solution and the fourth solution may each independently include at least one hole transfer material selected from among poly(3,4-ethylenedioxythiophene) (PEDOT), poly(styrenesulfonate) (PSS), polyaniline, phthalocyanine, pentacene, polydiphenylacetylene, poly(t-butyl)diphenylacetylene, poly(trifluoromethyl)diphenylacetylene, copper phthalocyanine (Cu-PC) poly(bistrifluoromethy)acetylene, polybis(t-butyldiphenyl)acetylene, poly(trimethylsilyl)diphenylacetylene, poly(carbazole)diphenylacetylene, polydiacetylene, polyphenylacetylene, polypyridineacetylene, polymethoxyphenylacetylene, polymethylphenylacetylene, poly(t-butyl)phenylacetylene, polynitrophenylacetylene, poly(trifluoromethyl)phenylacetylene, poly(trimethylsilyl)phenylacetylene and combinations thereof.

Preferably, the third solution and the fourth solution may include a mixture of poly(3,4-ethylenedioxythiophene) (PEDOT) and poly(styrenesulfonate) (PSS). Herein, the mixture of poly(3,4-ethylenedioxythiophene) and poly(styrenesulfonate) may have a weight ratio of 1:1 to 1:5, preferably 1:2 to 1:3.

The third solution includes, together with the hole transfer material described above, water as a solvent for minimizing a surface energy difference with the photoactive layer formed in the previous step and preventing contraction that may occur during laminating and drying processes. In addition, one or more additives may be included for facilitating thin film formation on the hydrophobic surface.

The additive is for reducing a surface energy difference with the photoactive layer, and is not particularly limited as long as it is an additive used in the art such as a surface energy controlling agent, a coating property improving additive and a surfactant.

The third solution may have viscosity (25°C) of 10 cps to 30 cps, preferably 15 cps to 25 cps. When the third solution has viscosity of less than 10 cps, a diffusion phenomenon occurs, and a thin film having desired sheet resistance is difficult to form. When the viscosity is greater than 30 cps, sheet resistance of a thin film becomes too high adversely affecting battery performance, and problems of declining thin film binding property and uniformity may occur.

As one example, the third solution for forming the first hole transfer layer includes PEDOT:PSS that is a conductive polymer, and water, and is prepared to have viscosity of 10 cps to 30 cps, and the PEDOT:PSS is made in an ink form so as to be slot die coated on the photoactive layer that is hydrophobic. An additive and a surfactant are used in the ink for increasing energy conversion efficiency through enhancing morphology by improving wettability and slip property.

The prepared third solution is slot die coated on the photoactive layer and heat treated for 20 minutes at 120°C to form the first hole transfer layer having a thickness of 100 nm to 500 nm.

Herein, the PEDOT and the PSS may preferably have a weight ratio of 1:2 to 1:3.

As described above, the first hole transfer layer (50) has sheet resistance of 1x10⁴ Ω/sq. to 1x10⁶ Ω/sq., and in this range, battery performance and a stability improvement effect may be obtained.

The first hole transfer layer (50) has a thickness of 100 nm to 500 nm, preferably has a thickness of 200 nm to 300 nm. When the first hole transfer layer (50) has a thickness in the above-mentioned range, adhesion with the photoactive layer at the bottom is improved more and the second hole transfer layer may be uniformly formed.

The fourth solution may include alcohol-based solvents to uniformly disperse the hole transfer material described above, and facilitate volatilization during a drying process in the thin film formation.

The alcohol-based solvent comprises at least one selected from the group consisting of 2-ethylhexanol, 2-butoxyethanol, dipropylene glycol, ethylene glycol, n-propyl alcohol, isopropyl alcohol and propylene glycol. Preferably, propylene glycol or isopropyl alcohol may be used.

The fourth solution may have viscosity (25°C) of 300 cps to 500 cps, preferably 400 cps to 450 cps. When the viscosity of the fourth solution is less than 300 cps, sheet resistance of the thin film and diffusion property increase. When the viscosity is greater than 500 cps, sheet resistance becomes too low causing a problem in the performance, and processibility declines since uniform dispersion of the hole transfer material is difficult.

As one example, the fourth solution for forming the second hole transfer layer includes PEDOT:PSS that is a conductive polymer, and an organic-based solvent, and is prepared to have viscosity of 300 cps to 500 cps, the PEDOT:PSS is made in an ink form so as to be slot die coated on the first hole transfer layer formed above.

The fourth solution prepared as above is slot die coated on the first hole transfer layer and heat treated for 20 minutes at 120°C to form a second hole transfer layer having a thickness of 1,000 nm to 5,000 nm.

Herein, the PEDOT and the PSS may preferably have a weight ratio of 1:2 to 1:3.

The second hole transfer layer (51) has sheet resistance of 1x10² Ω to 1x10³ Ω. When the sheet resistance is less than the above-described range, the thickness of the second hole transfer layer increases for battery driving, which is disadvantageous in obtaining a thin-filmed and flexible organic photovoltaic cell. When the sheet resistance is greater than the above-described range, resistance increases declining battery performance.

The second hole transfer layer (51) has a thickness of 1,000 nm to 5,000 nm, preferably 2, 000 nm to 4,000 nm. When the thickness of the second hole transfer layer (51)is in the above-described range, penetration of impurities, metal ions and the like from an upper electrode may be more effectively prevented, and durability is excellent.

In the present disclosure, the first hole transfer layer (50) and the second hole transfer layer (51) have a thickness ratio of 1:10 to 1:50, preferably 1:10 to 1:20. When the thickness ratio is less than the above-mentioned range, the second hole transfer layer (51) becomes too thin reducing hole mobility, and when the thickness ratio is greater than the above-mentioned range, the first hole transfer layer (50) becomes too thin and does not function as an interlayer causing a contraction problem of the second hole transfer layer (51).

The hole transfer layers (50, 51) form a film by coating the third solution and the fourth solution, respectively. Herein, the coating may be carried out through at least one method selected from among a slot die coating method, a bar coating method, a meyer bar coating method, a spin coating method, a comma coating method, a curtain coating method, a microgravure coating method, an inkjet coating method, a spray coating method, a doctor blade coating method or the like. Preferably, a slot die coating method may be used.

In existing methods for manufacturing an organic photovoltaic cell, a pattern and a thickness of each layer have been dependent on a method of discharging a solution. Accordingly, in existing methods for manufacturing an organic photovoltaic cell, a slot die coating method has been normally used for forming a layer with constant pattern and thickness. However, the slot die coating method has a problem in that mass production is difficult since layers having uniform pattern and thickness are difficult to be repeatedly formed depending on solution viscosity, manufacturing environments and user skill (refer to FIG. 2).

However, the present disclosure provides advantages in that the layer interface has an excellent binding property, and TD contraction and thickness contraction do not occur even when forming the photoactive layer and the hole transfer layer in a contactless manner through a slot die coating method and the like. Accordingly, layers having target design values of pattern width and thickness may be formed when manufacturing the organic photovoltaic cell of the present disclosure.

The upper electrode (60) is located on the second hole transfer layer (51) described above, and performs a role of a positive electrode.

The upper electrode (60) is a metal electrode layer normally having low work function. For example, the metal may include particles of metals such as silver (Ag), copper (Cu), gold (Au), platinum (Pt), titanium (Ti), aluminum (Al), nickel (Ni), zirconium (Zr), iron (Fe) and manganese (Mn); or precursors including the metal elements, for example, silver nitrate (AgNO₃), Cu(hexafluoroacetylacetonate)₂ (Cu(HAFC)₂), Cu(HAFC)(1,5-cyclooctanediene), Cu(HAFC)(1,5-dimethylcyclooctanediene), Cu(HAFC)(4-methyl-1-pentene), Cu(HAFC)(vinylcyclohexane), Cu(HAFC)(DMB), Cu (tetramethylheptanedionate)₂ (Cu(TMHD)₂), dimethylaluminum hydride (DMAH), tetramethylethylenediamine (TMEDA), dimethylethylamine alane (DMEAA, NMe₂Et·AlH₃), trimethylaluminum (TMA), triethylaluminum (TEA), triisobutylaluminum (TBA), tetra(dimethylamino)titanium (TDMAT), tetra(dimethylamino)titanium (TDEAT) and the like, however, the material is not limited thereto.

The upper electrode (60) may have a thickness of 10 nm to 5000 nm.

Such the upper electrode (60) may be formed using methods commonly known in the technology field to which the present disclosure belongs. For example, the upper electrode (60) may be formed using methods such as screen printing, gravure printing, gravure-offset printing, thermal vapor deposition, electron beam deposition, RF or magnetron sputtering and chemical deposition.

### Example 1 and Comparative Example 1: Manufacture of Organic Photovoltaic Cell

### [Example 1]

While transporting an ITO layer-formed substrate in a roll-to-roll manner, a zinc oxide-containing coating solution (prepared by mixing 247 mg of Zn(OAC)₂·2H₂O, 126 mg of KOH and 1 ml of 1-butanol) was slot die coated on the ITO layer in a stripe pattern (pattern width: 8,500 µm), and then the result was dried at 120°C to form an electron transfer layer to a thickness of 0.03 µm. In the slot die coating, the line speed was 12 mm/sec, the slot die height was 1300 µm, and the coating solution flow rate was 0.4 ml/min.

Subsequently, a coating solution for forming a photoactive layer (prepared by mixing 15 mg of lisicon® SP001 (manufactured by Merck & Co. Inc.), 12 mg of lisicon® A-600 (manufactured by Merck & Co. Inc.) and 1 ml of 1,2-dichlorobenzene) was slot die coated on the electron transfer layer, and then the result was dried at 120°C to form a photoactive layer to a thickness of 0.3 µm. In the slot die coating, the line speed was 12 mm/sec, the slot die height was 1500 µm, and the coating solution flow rate was 1.2 ml/min.

On the photoactive layer, a composition for forming a first hole transfer layer including PEDOT:PSS (HTL-solar®, manufactured by Heraeus) and water was slot die coated, and the result was dried at 120°C to form a first hole transfer layer to a thickness of 0.5 µm. Herein, viscosity of the composition for forming a first hole transfer layer was 20 cps.

Next, a composition for forming a second hole transfer layer including PEDOT:PSS (Orgacon® EL-P 5010, manufactured by Agfa) and isopropyl alcohol was slot die coated on the first hole transfer layer, and the result was dried at 120°C to form a second hole transfer layer to a thickness of 5 µm. Herein, viscosity of the composition for forming a second hole transfer layer was 1,000 cps. In the slot die coating of the first hole transfer layer and the second hole transfer layer, the line speed was 5 mm/sec, the slot die height was 800 µm, and the coating solution flow rate was 3.0 ml/min.

After that, an Ag electrode (thickness 10 µm) was printed on the hole transfer layer using a screen printer to manufacture an organic photovoltaic cell.

### [Comparative Example 1]

An organic photovoltaic cell was manufactured in the same manner as in Example 1 except that the second hole transfer layer of Example 1 was not formed, and a hole transfer layer having a thickness of 0.5 µm was formed using only the composition for forming a first hole transfer layer.

### Test Example 1: Evaluation on Thin Film Property

Each thin film was formed by coating each of the composition for forming a first hole transfer layer and the composition for forming a second hole transfer layer used in Example 1 on a substrate, and drying the result in a hot plate under a condition of 120°C.

Sheet resistance was measured for each of the formed thin films using a 4-point probe method (Keithley 2400 Source Meter).

As a result, the first hole transfer layer had sheet resistance of 1x10⁶ Ω/sq. and the second hole transfer layer had sheet resistance of 1x10² Ω/sq.. Through the results, it was seen that the first hole transfer layer and the second hole transfer layer each had a different thin film property.

### Test Example 2: Evaluation on Lifespan of Organic Photovoltaic Cell

In order to evaluate lifespan of the organic photovoltaic cells manufactured in Example 1 and Comparative Example 1, identical sunlight was irradiated on the organic photovoltaic cells, and power-conversion efficiency (PCE) depending on the passage of time was evaluated.

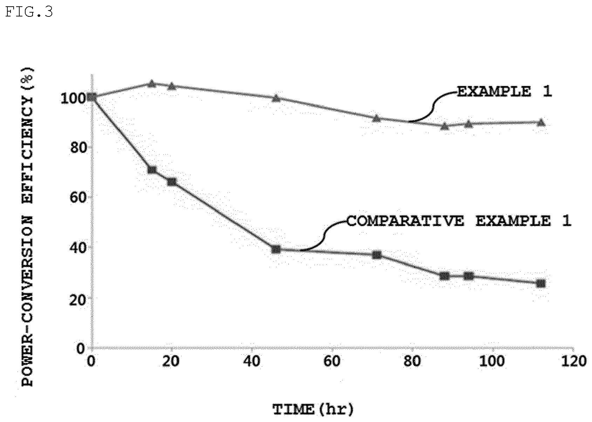

The evaluation was measured as a (E1/E0)^{∗}100 value when initial power-conversion efficiency was employed as E0, and efficiency after the passage of time was employed as E1, and it was preferable to maintain initial power-conversion efficiency for a long period of time. The evaluation results are shown in FIG. 3.

As shown in FIG. 3, it was confirmed that Comparative Example 1 including a single layer of hole transfer layer formed from a composition with low viscosity had a significantly large power-conversion efficiency drop over time compared to the organic photovoltaic cell of Example 1. In addition, it was confirmed that the organic photovoltaic cell of Example 1 maintained initial power-conversion efficiency for approximately 100 hours or longer.

In other words, it can be seen that, since the organic photovoltaic cell of the present disclosure includes a double layer-structured hole transfer layer exhibiting different sheet resistance prepared from compositions for forming a hole transfer layer having low viscosity and high viscosity, a binding property with the photoactive layer and uniformity are excellent, and excellent performance is maintained for a long period of time by effectively blocking the inflow of impurities from an upper electrode.

### [Reference Numeral]

- 10:: Substrate
- 20:: Lower Electrode
- 30:: Electron Transfer Layer
- 40:: Photoactive Layer
- 50:: First Hole Transfer Layer
- 51:: Second Hole Transfer Layer
- 60:: Upper Electrode

## Claims

1. An organic photovoltaic cell, comprising: a substrate (10); a lower electrode (20); an electron transfer layer (30); a photoactive layer (40); a first hole transfer layer (50); a second hole transfer layer (51); and an upper electrode (60) are sequentially laminated on the substrate,
wherein the first hole transfer layer (50) has higher sheet resistance than the second hole transfer layer (51), **characterized in that** the first hole transfer layer (50) has a thickness of 100 nm to 500 nm and, the second hole transfer (51) layer has a thickness of 1,000 nm to 5,000 nm.

2. The organic photovoltaic cell of Claim 1, wherein the first hole transfer layer (50) has sheet resistance of 1x10⁴ Ω/sq. to 1x10 ⁶Ω/sq..

3. The organic photovoltaic cell of Claim 1, wherein the second hole transfer (51) layer has sheet resistance of 1x10 ²Ω/sq. to 1x10³ Ω/sq..

4. The organic photovoltaic cell of Claim 1, wherein the first hole transfer layer (50) and the second hole transfer layer (51) respectively comprise at least one hole transfer material selected from the group consisting of poly(3,4-ethylenedioxythiophene), poly(styrenesulfonate), polyaniline, phthalocyanine, pentacene, polydiphenylacetylene, poly(t-butyl)diphenylacetylene, poly(trifluoromethyl)diphenylacetylene, copper phthalocyanine poly(bistrifluoromethyl)acetylene, polybis(t-butyldiphenyl)acetylene, poly(trimethylsilyl)diphenylacetylene, poly(carbazole)diphenylacetylene, polydiacetylene, polyphenylacetylene, polypyridineacetylene, polymethoxyphenylacetylene, polymethylphenylacetylene, poly(t-butyl)phenylacetylene, polynitrophenylacetylene, poly(trifluoromethyl)phenylacetylene, poly(trimethylsilyl)phenylacetylene and combinations thereof.

5. The organic photovoltaic cell of Claim 1, wherein the lower electrode (20) is a negative electrode, and the upper electrode (60) is a positive electrode.

6. The organic photovoltaic cell of Claim 1, which has an inverted electrode structure.

7. A method for manufacturing an organic photovoltaic cell comprising:
1) forming a lower electrode (20) on a substrate (10);
2) forming an electron transfer layer (30) on the lower electrode (20) using a composition for forming an electron transfer layer (30);
3) forming a photoactive layer (40) on the electron transfer layer (30) using a composition for forming a photoactive layer (40);
4) forming a first hole transfer (50) layer on the photoactive layer (40) using a composition for forming a first hole transfer layer (50);
5) forming a second hole transfer layer (51) on the first hole transfer layer (50) using a composition for forming a second hole transfer layer (51); and
6) forming an upper electrode (60) on the second hole transfer layer (51),
wherein the first hole transfer layer (50) is formed using a composition having lower viscosity than the composition for forming a second hole transfer layer (51), **characterized in that** the first hole transfer layer (50) has a thickness of 100 nm to 500 nm and, the second hole transfer layer (51) has a thickness of 1,000 nm to 5,000 nm.

8. The method for manufacturing an organic photovoltaic cell of Claim 7, wherein a viscosity ratio between the composition for forming a first and a second hole transfer layer (50, 51) is 1:10 or more.

9. The method for manufacturing an organic photovoltaic cell of Claim 7, wherein a viscosity ratio between the composition for forming a first and a second hole transfer layer (50, 51) is 1:10 to 1:50.

10. The method for manufacturing an organic photovoltaic cell of Claim 7, wherein the composition for forming a first hole transfer layer (50) has a viscosity (25°C) of 10 cps to 30 cps.

11. The method for manufacturing an organic photovoltaic cell of Claim 7, wherein the composition for forming a second hole transfer layer (51) has viscosity (25°C) of 300 cps to 500 cps.

12. The method for manufacturing an organic photovoltaic cell of Claim 7, wherein the first hole transfer layer (50) and the second hole transfer layer (51) are formed by slot die coating.

## Patentansprüche

1. Organische Photovoltaikzelle, umfassend:
ein Substrat (10);
eine untere Elektrode (20);
eine Elektronentransferschicht (30);
eine photoaktive Schicht (40);
eine erste Lochtransferschicht (50);
eine zweite Lochtransferschicht (51); und
eine obere Elektrode (60), die nacheinander auf das Substrat laminiert werden, wobei die erste Lochtransferschicht (50) einen höheren Schichtwiderstand als die zweite Lochtransferschicht (51) aufweist, **dadurch gekennzeichnet, dass** die erste Lochtransferschicht (50) eine Dicke von 100 nm bis 500 nm aufweist, und die zweite Lochtransferschicht (51) eine Dicke von 1.000 nm bis 5.000 nm aufweist.

2. Organische Photovoltaikzelle nach Anspruch 1, wobei die erste Lochtransferschicht (50) einen Schichtwiderstand von 1×10⁴ Ω/² bis 1×10⁶ Ω/² aufweist.

3. Organische Photovoltaikzelle nach Anspruch 1, wobei die zweite Lochtransferschicht (51) einen Schichtwiderstand von 1×10² Ω/² bis 1×10³ Ω/² aufweist.

4. Organische Photovoltaikzelle nach Anspruch 1, wobei die erste Lochtransferschicht (50) und die zweite Lochtransferschicht (51) jeweils wenigstens ein Lochtransfermaterial umfassen, das aus der Gruppe ausgewählt ist, das Poly(3,4-ethylendioxythiophen), Poly(styrensulfonat), Polyanilin, Phthalocyanin, Pentacen, Polydiphenylacetylen, Poly(t-butyl)diphenylacetylen, Poly(trifluormethyl)diphenylacetylen, Kupferphthalocyanin, Poly(bistrifluormethyl)acetylen, Polybis(t-butyldiphenyl)acetylen, Poly(trimethylsilyl)diphenylacetylen, Poly(carbazol)diphenylacetylen, Polydiacetylen, Polyphenylacetylen, Polypyridinacetylen, Polymethoxyphenylacetylen, Polymethylphenylacetylen, Poly(t-butyl)phenylacetylen, Polynitrophenylacetylen, Poly(trifluormethyl)phenylacetylen, Poly(trimethylsilyl)phenylacetylen und Kombinationen davon besteht.

5. Organische Photovoltaikzelle nach Anspruch 1, wobei die untere Elektrode (20) eine negative Elektrode ist, und die obere Elektrode (60) eine positive Elektrode ist.

6. Organische Photovoltaikzelle nach Anspruch 1, die eine invertierte Elektrodenstruktur aufweist.

7. Verfahren zum Herstellen einer organischen Photovoltaikzelle, umfassend:
1) Ausbilden einer unteren Elektrode (20) auf einem Substrat (10);
2) Ausbilden einer Elektronentransferschicht (30) auf der unteren Elektrode (20) unter Verwendung einer Zusammensetzung zum Ausbilden einer Elektronentransferschicht (30);
3) Ausbilden einer photoaktiven Schicht (40) auf der Elektronentransferschicht (30) unter Verwendung einer Zusammensetzung zum Ausbilden einer photoaktiven Schicht (40);
4) Ausbilden einer ersten Lochtransferschicht (50) auf der photoaktiven Schicht (40) unter Verwendung einer Zusammensetzung zum Ausbilden einer ersten Lochtransferschicht (50);
5) Ausbilden einer zweiten Lochtransferschicht (51) auf der ersten Lochtransferschicht (50) unter Verwendung einer Zusammensetzung zum Ausbilden einer zweiten Lochtransferschicht (51); und
6) Ausbilden einer oberen Elektrode (60) auf der zweiten Lochtransferschicht (51),
wobei die erste Lochtransferschicht (50) unter Verwendung einer Zusammensetzung, die eine niedrigere Viskosität als die Zusammensetzung zum Ausbilden einer zweiten Lochtransferschicht (51) aufweist, ausgebildet wird, **dadurch gekennzeichnet, dass** die erste Lochtransferschicht (50) eine Dicke von 100 nm bis 500 nm aufweist, und die zweite Lochtransferschicht (51) eine Dicke von 1.000 nm bis 5.000 nm aufweist.

8. Verfahren zum Herstellen einer organischen Photovoltaikzelle nach Anspruch 7, wobei ein Viskositätsverhältnis zwischen den Zusammensetzungen zum Ausbilden einer ersten und einer zweiten Lochtransferschicht (50, 51) wenigstens 1:10 beträgt.

9. Verfahren zum Herstellen einer organischen Photovoltaikzelle nach Anspruch 7, wobei ein Viskositätsverhältnis zwischen den Zusammensetzungen zum Ausbilden einer ersten und einer zweiten Lochtransferschicht (50, 51) 1:10 bis 1:50 beträgt.

10. Verfahren zum Herstellen einer organischen Photovoltaikzelle nach Anspruch 7, wobei die Zusammensetzung zum Ausbilden einer ersten Lochtransferschicht (50) eine Viskosität (25 °C) von 10 cP bis 30 cP aufweist.

11. Verfahren zum Herstellen einer organischen Photovoltaikzelle nach Anspruch 7, wobei die Zusammensetzung zum Ausbilden einer zweiten Lochtransferschicht (51) eine Viskosität (25 °C) von 300 cP bis 500 cP aufweist.

12. Verfahren zum Herstellen einer organischen Photovoltaikzelle nach Anspruch 7, wobei die erste Lochtransferschicht (50) und die zweite Lochtransferschicht (51) durch Schlitzdüsenbeschichtung ausgebildet werden.

## Revendications

1. Cellule photovoltaïque organique, comprenant : un substrat (10) ; une électrode inférieure (20) ; une couche de transfert d'électrons (30) ; une couche photoactive (40) ; une première couche de transfert de trous (50) ; une seconde couche de transfert de trous (51) ; et une électrode supérieure (60) est laminée séquentiellement sur le substrat,
dans laquelle la première couche de transfert de trous (50) a une résistance-carrée plus élevée que la seconde couche de transfert de trous (51), **caractérisée en ce que** la première couche de transfert de trous (50) a une épaisseur de 100 nm à 500 nm et, la seconde couche de transfert de trous (51) a une épaisseur de 1 000 nm à 5 000 nm.

2. Cellule photovoltaïque organique selon la revendication 1, dans laquelle la première couche de transfert de trous (50) a une résistance-carrée de 1 × 10⁴ Q/sq. à 1 × 10⁶ Q/sq..

3. Cellule photovoltaïque organique selon la revendication 1, dans laquelle la seconde couche de transfert de trous (51) a une résistance-carrée de 1 × 10² Q/sq. à 1 × 10³ Q/sq..

4. Cellule photovoltaïque organique selon la revendication 1, dans laquelle la première couche de transfert de trous (50) et la seconde couche de transfert de trous (51) comprennent respectivement au moins un matériau de transfert de trous sélectionné dans le groupe constitué de poly(3,4-éthylènedioxythiophène), poly(styrènesulfonate), polyaniline, phtalocyanine, pentacène, polydiphénylacétylène, poly(t-butyl)diphénylacétylène, poly(trifluorométhyl)diphénylacétylène, phtalocyanine de cuivre poly(bistrifluorométhyl)acétylène, polybis(t-butyldiphényl)acétylène, poly(triméthylsilyl)diphénylacétylène, poly(carbazole)diphénylacétylène, polydiacétylène, polyphénylacétylène, polypyridine acétylène, polyméthoxyphénylacétylène, polyméthylphénylacétylène, poly(t-butyl)phénylacétylène, polynitrophénylacétylène, poly(trifluorométhyl)phénylacétylène, poly(triméthylsilyl)phénylacétylène et des combinaisons de ceux-ci.

5. Cellule photovoltaïque organique selon la revendication 1, dans laquelle l'électrode inférieure (20) est une électrode négative et l'électrode supérieure (60) est une électrode positive.

6. Cellule photovoltaïque organique selon la revendication 1, qui a une structure d'électrode inversée.

7. Procédé de fabrication d'une cellule photovoltaïque organique comprenant :
1) la formation d'une électrode inférieure (20) sur un substrat (10) ;
2) la formation d'une couche de transfert d'électrons (30) sur l'électrode inférieure (20) à l'aide d'une composition destinée à former une couche de transfert d'électrons (30) ;
3) la formation d'une couche photoactive (40) sur la couche de transfert d'électrons (30) à l'aide d'une composition destinée à former une couche photoactive (40) ;
4) la formation d'une première couche de transfert de trous (50) sur la couche photoactive (40) à l'aide d'une composition destinée à former une première couche de transfert de trous (50) ;
5) la formation d'une seconde couche de transfert de trous (51) sur la première couche de transfert de trous (50) à l'aide d'une composition destinée à former une seconde couche de transfert de trous (51) ; et
6) la formation d'une électrode supérieure (60) sur la seconde couche de transfert de trous (51),
dans lequel la première couche de transfert de trous (50) est formée à l'aide d'une composition ayant une viscosité inférieure à la composition destinée à former une seconde couche de transfert de trous (51), **caractérisée en ce que** la première couche de transfert de trous (50) a une épaisseur de 100 nm à 500 nm et la seconde couche de transfert de trous (51) a une épaisseur de 1 000 nm à 5 000 nm.

8. Procédé de fabrication d'une cellule photovoltaïque organique selon la revendication 7, dans lequel un rapport de viscosité entre la composition destinée à former une première et la composition destinée à former une seconde couche de transfert de trous (50, 51) est de 1:10 ou plus.

9. Procédé de fabrication d'une cellule photovoltaïque organique selon la revendication 7, dans lequel un rapport de viscosité entre la composition destinée à former une première et la composition destinée à former une seconde couche de transfert de trous (50, 51) est de 1:10 à 1:50.

10. Procédé de fabrication d'une cellule photovoltaïque organique selon la revendication 7, dans lequel la composition destinée à former une première couche de transfert de trous (50) a une viscosité (25 °C) de 10 cP à 30 cP.

11. Procédé de fabrication d'une cellule photovoltaïque organique selon la revendication 7, dans lequel la composition destinée à former une seconde couche de transfert de trous (51) a une viscosité (25 °C) de 300 cP à 500 cP.

12. Procédé de fabrication d'une cellule photovoltaïque organique selon la revendication 7, dans lequel la première couche de transfert de trous (50) et la seconde couche de transfert de trous (51) sont formées par un revêtement de filière en forme de fente.
